# EUROPEAN PATENT APPLICATION

(11) **EP 4 394 858 A1**
(43) Date of publication of application: **03.07.2024**
(21) Application number: 23196815.7
(22) Date of filing: 12.09.2023
(51) Int. Cl.: H01L 21/8238, H01L 27/092, H01L 29/08, H01L 29/417

(54) **SEMICONDUCTOR DEVICE AND METHOD FOR FABRICATING THE SAME**

(30) Priority: 28.12.2022 KR 20220187102
(71) Applicant: Samsung Electronics Co., Ltd., Suwon-si, Gyeonggi-do 16677 (KR)
(72) Inventor: KIM, Young Gwon, 16677 Suwon-si, Gyeonggi-do (KR); KANG, Myung Gil, 16677 Suwon-si, Gyeonggi-do (KR); JEONG, Soo Jin, 16677 Suwon-si, Gyeonggi-do (KR); KIM, Dong Won, 16677 Suwon-si, Gyeonggi-do (KR); PARK, Beom Jin, 16677 Suwon-si, Gyeonggi-do (KR); YANG, Hong Seon, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate that includes a first region and a second region, a first active pattern on the first region, a first gate structure that intersects the first active pattern, a first epitaxial pattern connected to the first active pattern and includes n-type impurities, a first source/drain contact that penetrates an upper surface of the first epitaxial pattern and is connected to the first epitaxial pattern, a second active pattern on the second region, a second gate structure that intersects the second active pattern, a second epitaxial pattern connected to the second active pattern and includes p-type impurities, and a second source/drain contact that penetrates an upper surface of the second epitaxial pattern and is connected to the second epitaxial pattern. A lower surface of the first source/drain contact is lower than a lower surface of the second source/drain contact.

## Description

### CROSS-REFERENCE TO RELATED APPLICATION

This application claims priority under 35 U.S.C. 119 from Korean Patent Application No. 10-2022-0187102, filed on December 28, 2022 in the Korean Intellectual Property Office, the contents of which are herein incorporated by reference in their entirety.

### TECHNICAL FIELD

Embodiments of the present disclosure are directed to a semiconductor device and a method for fabricating the same. More specifically, embodiments of the present disclosure are directed to a semiconductor device that includes a multi-bridge channel, and a method for fabricating the same.

### DISCUSSION OF THE RELATED ART

A scaling technology for increasing density of semiconductor devices includes a multi gate transistor in which a multi-channel active pattern, or a silicon body, that has a fin or nanowire shape is formed on a substrate and a gate is formed on a surface of the multi-channel active pattern.

Since such a multi gate transistor utilizes a three-dimensional channel, scaling is easily performed. Further, even if a gate length of the multi gate transistor is not increased, the current control capability can be increased. Furthermore, a short channel effect (SCE) in which the potential of a channel region is influenced by a drain voltage can be effectively suppressed.

### SUMMARY

Embodiments of the present disclosure provide a semiconductor device with increased performance.

Embodiments of the present disclosure provide a method for manufacturing a semiconductor device with increased performance.

According to an embodiment of the present disclosure, there is provided a semiconductor device that includes a substrate that includes a first region and a second region, a first active pattern that extends in a first direction on the first region, a first gate structure that extends in a second direction that intersects the first direction and intersects the first active pattern, a first epitaxial pattern disposed on a side surface of the first gate structure and that is connected to the first active pattern and includes n-type impurities, a first source/drain contact that penetrates an upper surface of the first epitaxial pattern and is connected to the first epitaxial pattern, a second active pattern that extends in a third direction on the second region, a second gate structure that extends in a fourth direction that intersects the third direction and intersects the second active pattern, a second epitaxial pattern disposed on a side surface of the second gate structure and that is connected to the second active pattern and includes p-type impurities, and a second source/drain contact that penetrates an upper surface of the second epitaxial pattern and is connected to the second epitaxial pattern. A lower surface of the first source/drain contact is lower than a lower surface of the second source/drain contact.

According to another embodiment of the present disclosure, there is provided a semiconductor device that includes a substrate that includes a first region and a second region, a first active pattern that extends in a first direction on the first region, a first gate structure that extends in a second direction that intersects the first direction and intersects the first active pattern, a first epitaxial pattern disposed on a side surface of the first gate structure and that is connected to the first active pattern and includes n-type impurities, a first source/drain contact that penetrates an upper surface of the first epitaxial pattern and is connected to the first epitaxial pattern, a second active pattern that extends in a third direction on the second region, a second gate structure that extends in a fourth direction that intersects the third direction and intersects the second active pattern, a second epitaxial pattern disposed on a side surface of the second gate structure and that is connected to the second active pattern and includes p-type impurities, and a second source/drain contact that penetrates an upper surface of the second epitaxial pattern and is connected to the second epitaxial pattern. The upper surface of the first epitaxial pattern has a V shape in a cross-section that intersects the second direction, and an uppermost part of the second epitaxial pattern is higher than an uppermost part of the first epitaxial pattern.

According to still another embodiment of the present disclosure, there is provided a semiconductor device that includes a substrate that includes a NFET region and a PFET region, a plurality of first sheet patterns that are sequentially stacked on the NFET region, vertically spaced apart from each other, and extend in a first direction, a first gate structure that extends in a second direction that intersects the first direction and is penetrated by the plurality of first sheet patterns, a first epitaxial pattern disposed on a side surface of the first gate structure and that is connected to the plurality of first sheet patterns, a first source/drain contact that penetrates an upper surface of the first epitaxial pattern and is connected to the first epitaxial pattern, a plurality of second sheet patterns that are sequentially disposed on the PFET region, vertically spaced apart from each other, and extend in a third direction, a second gate structure that extends in a fourth direction that intersects the third direction and is penetrated by the plurality of second sheet patterns, a second epitaxial pattern disposed on a side surface of the second gate structure and that is connected to the plurality of second sheet patterns, and a second source/drain contact that penetrates an upper surface of the second epitaxial pattern and is connected to the second epitaxial pattern. An upper surface of the first epitaxial pattern forms a V shape in a cross-section that intersects the second direction, an uppermost part of the second epitaxial pattern is higher than an uppermost part of the first epitaxial pattern, and a lower surface of the first source/drain contact is lower than a lower surface of the second source/drain contact.

### BRIEF DESCRIPTION OF THE DRAWINGS

FIG. 1 is a perspective view if a semiconductor device according to some embodiments.
FIG. 2 is a cross-sectional view taken along lines A1-A1 and A2-A2 of FIG. 1.
FIGS. 3A and 3B are enlarged views of a region R1 and a region R2 of FIG. 2.
FIG. 4 is a cross-sectional view taken along lines B1-B1 and B2-B2 of FIG. 1.
FIG. 5 is a cross-sectional view taken along lines C1-C1 and C2-C2 of FIG. 1.
FIG. 6 is another cross-sectional view taken along lines A1-A1 and A2-A2 of FIG. 1.
FIG. 7 is an enlarged view of a region R1 and a region R2 of FIG. 6.
FIGS. 8 to 10 are various other cross-sectional views taken along lines A1-A1 and A2-A2 of FIG. 1.
FIG. 11 is another cross-sectional view taken along lines A1-A1 and A2-A2 of FIG. 1.
FIGS. 12 to 25 illustrate intermediate steps of a method for fabricating a semiconductor device according to some embodiments.
FIGS. 26 and 27 illustrate intermediate steps of a method for fabricating a semiconductor device according to some embodiments.

### DETAILED DESCRIPTION

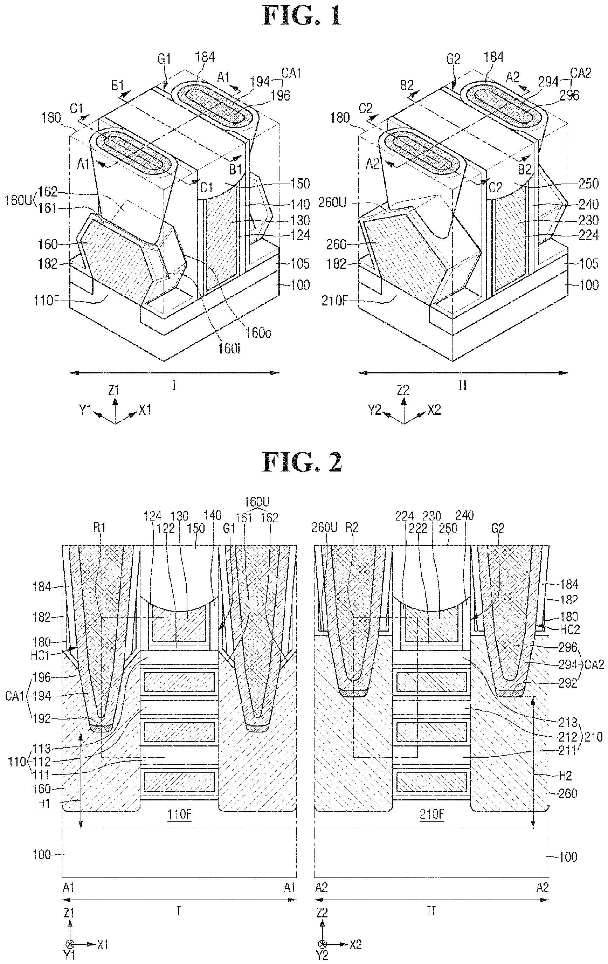

A semiconductor device according to example embodiments will be described below with reference to FIGS. 1 to 11.

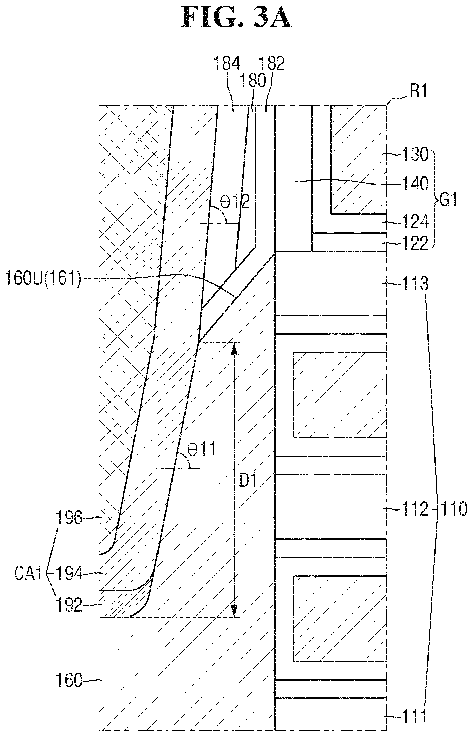

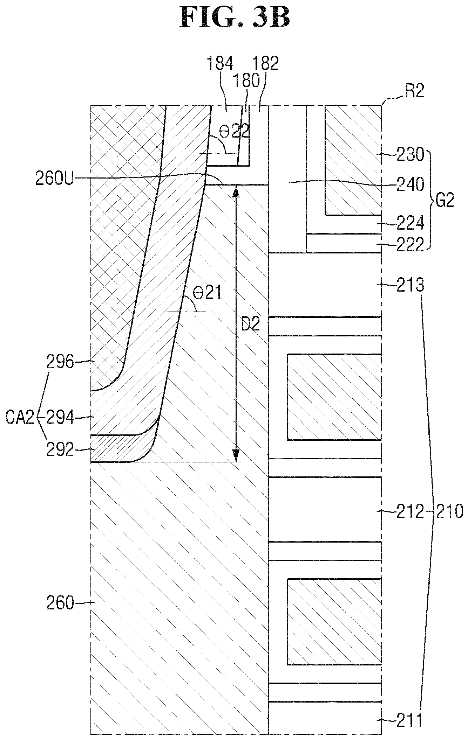

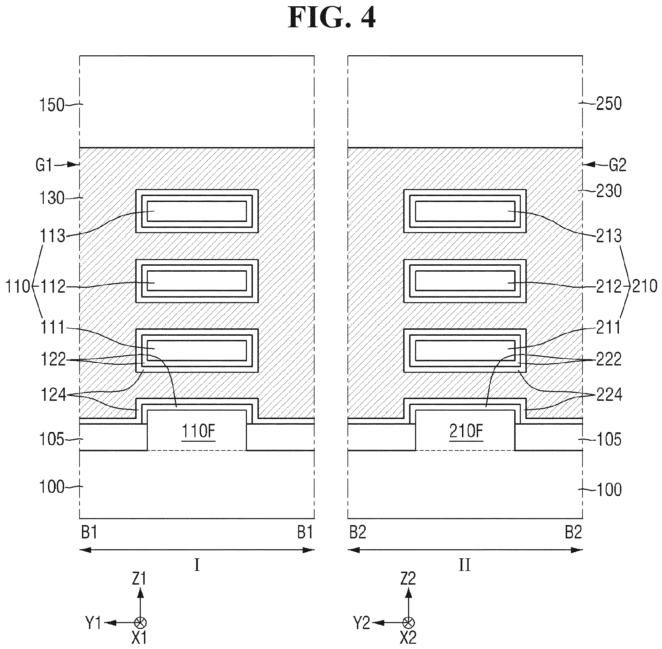

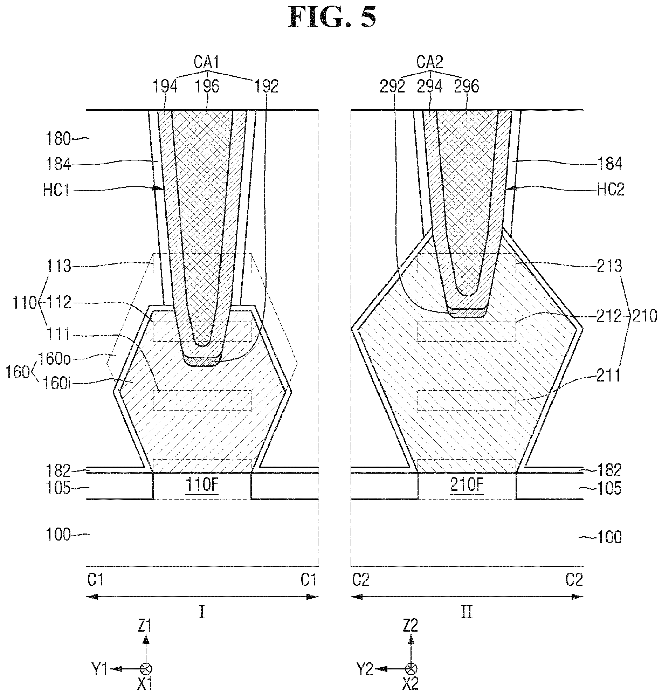

FIG. 1 is a perspective view of a semiconductor device according to some embodiments. FIG. 2 is a cross-sectional view taken along lines A1-A1 and A2-A2 of FIG. 1. FIGS. 3A and 3B are enlarged views of a region R1 and a region R2 of FIG. 2. FIG. 4 is a cross-sectional view taken along lines B1-B1 and B2-B2 of FIG. 1. FIG. 5 is a cross-sectional view taken along liens C1-C1 and C2-C2 of FIG. 1.

Referring to FIGS. 1 to 5, a semiconductor device according to some embodiments includes a substrate 100, a field insulating film 105, a first active pattern 110, a second active pattern 210, a first gate structure G1, a second gate structure G2, a first epitaxial pattern 160, a second epitaxial pattern 260, an interlayer insulating film 180, a first source/drain contact CA1, and a second source/drain contact CA2.

In some embodiments, the substrate 100 is a silicon substrate or an SOI (silicon-on-insulator). In some embodiments, the substrate 100 is a silicon substrate, or includes, but is not necessarily limited to, other materials, such as one or more of silicon germanium, SGOI (silicon germanium on insulator), indium antimonide, lead tellurium compounds, indium arsenic, indium phosphide, gallium arsenide or gallium antimonide. In some embodiments, the substrate 100 is an epitaxial layer formed on a base substrate. For convenience of explanation, the substrate 100 will be described as a silicon substrate.

The substrate 100 includes a first region I and a second region II. The first region I and the second region II may be connected to each other or separated from each other. Transistors of different conductive types are formed in the first region I and the second region II. In the following description, the first region I will be described as a NFET region, and the second region II will be described as a PFET region.

In some embodiments, an upper surface of the substrate 100 includes a {100} crystal plane. For example, the upper surface of substrate 100 is one of a (-1 0 0) plane, a (0 1 0) plane, a (0 -1 0) plane, a (0 0 1) plane, or a (0 0 -1) plane.

A first active pattern 110 is formed on the first region I of the substrate 100. The first active pattern 110 extends in a first direction X1 parallel to the upper surface of the substrate 100. In addition, the first active pattern 110 is spaced apart from the substrate 100. In some embodiments, the first active patterns 110 includes a plurality of sheet patterns, such as first to third sheet patterns 111 to 113, that are sequentially stacked on the first region I, vertically spaced apart from each other, and each extend in the first direction X1. Such a first active pattern 110 may be used as a channel region of an MBCFET that includes a multi-bridge channel. The number of sheet patterns shown as being included in the first active pattern 110 is an example, and is not necessarily limited to the shown example.

In some embodiments, a first fin pattern 110F is formed between the substrate 100 and the first active pattern 110. The first fin pattern 110F protrudes from the upper surface of the substrate 100 and extends in the first direction X1. The first fin pattern 110F may be formed by etching a part of the substrate 100, or may be an epitaxial layer grown from the substrate 100.

A second active pattern 210 is formed on the second region II of the substrate 100. The second active pattern 210 extends in a fourth direction X2 parallel to the upper surface of the substrate 100. The fourth direction X2 may be parallel to the first direction X1, or may differ from the first direction X1. In addition, the second active pattern 210 is spaced apart from the substrate 100. In some embodiments, the second active pattern 210 includes a plurality of sheet patterns, such as fourth to sixth sheet patterns 211 to 213, that are sequentially stacked on the second region II, vertically spaced apart from each other, and each extend in the fourth direction X2. Such a second active pattern 210 may be used as the channel region of an MBCFET that includes a multi-bridge channel. The number of sheet patterns shown as being included in the second active pattern 210 is an example and is not necessarily limited to the shown example.

In some embodiments, a second fin pattern 210F is formed between the substrate 100 and the second active pattern 210. The second fin pattern 210F protrudes from the upper surface of the substrate 100 and extends in the fourth direction X2. The second fin pattern 210F may be formed by etching a part of the substrate 100 or may be an epitaxial layer grown from the substrate 100.

The first active pattern 110 and the second active pattern 210 each include silicon (Si) or germanium (Ge), which are elemental semiconductor materials. Alternatively, the first active pattern 110 and the second active pattern 210 each include a compound semiconductor, such as a group IV-IV compound semiconductor or a group III-V compound semiconductor. The group IV-IV compound semiconductor may be, for example, a binary compound or a ternary compound that includes two or more of carbon (C), silicon (Si), germanium (Ge) or fin (Sn), or a compound obtained by doping these elements with a group IV element. The group III-V compound semiconductor is, for example, one of a binary compound, a ternary compound or a quaternary compound formed by combining at least one of aluminum (Al), gallium (Ga) or indium (In) as a group III element with one of phosphorus (P), arsenic (As) or antimony (Sb) as a group V element.

In some embodiments, the first active pattern 110 and the second active pattern 210 are disposed at the same level. The expression "disposed at the same level" means disposition at the same height with respect to the upper surface of the substrate 100. For example, as shown in FIGS. 2, 4 and 5, the first to third sheet patterns 111 to 113 and the fourth to sixth sheet patterns 211 to 213 are disposed at the same height as each other.

A field insulating film 105 is formed on the substrate 100. The field insulating film 105 includes, for example, but is not necessarily limited to, at least one of silicon oxide, silicon nitride, silicon oxynitride, or combinations thereof.

In some embodiments, the field insulating film 105 covers at least a part of the side surface of the first fin pattern FP and at least a part of the side surface of the second fin pattern 210F. Although only an upper part of the first fin pattern FP and an upper part of the second fin pattern 210F are shown as protruding from the upper surface of the field insulating film 105, this is an example. For another example, the upper surface of the field insulating film 105 is coplanar the upper surface of the first fin pattern 110F and the upper surface of the second fin pattern 210F.

A first gate structure G1 is formed on the first region I of the substrate 100. The first gate structure G1 extends along the upper surface of the substrate 100 and the upper surface of the field insulating film 105. The first gate structure G1 intersects the first active pattern 110. For example, the first gate structure G1 extends in a second direction Y1 that is parallel to the upper surface of the substrate 100 and intersects the first direction X1. The first active pattern 110 extends in the first direction X1 and penetrates the first gate structure G1. For example, the first gate structure G1 surrounds each of the first to third sheet patterns 111 to 113.

A second gate structure G2 is formed on the second region II of the substrate 100. The second gate structure G2 extends along the upper surface of the substrate 100 and the upper surface of the field insulating film 105. The second gate structure G2 intersects the second active pattern 210. For example, the second gate structure G2 extend in a fifth direction Y2 that is parallel to the upper surface of the substrate 100 and intersects the fourth direction X2. The second active pattern 210 extends in the fourth direction X2 and penetrates the second gate structure G2. For example, the second gate structure G2 surrounds each of the fourth to sixth sheet patterns 211 to 213.

The first gate structure G1 includes a first gate dielectric film 124, a first gate electrode 130, a first gate spacer 140, and a first gate capping pattern 150. The second gate structure G2 includes a second gate dielectric film 224, a second gate electrode 230, a second gate spacer 240, and a second gate capping pattern 250.

The first gate dielectric film 124 is stacked on the first active pattern 110. A first gate dielectric film 124 surrounds the periphery of the first active pattern 110. In addition, the first gate dielectric film 124 extends along the upper surface of the field insulating film 105 and the surface of the first fin pattern 110F.

The second gate dielectric film 224 is stacked on the second active pattern 210. The second gate dielectric film 224 surrounds the periphery of the second active pattern 210. In addition, the second gate dielectric film 224 extends along the upper surface of the field insulating film 105 and the surface of the second fin pattern 210F.

The first gate dielectric film 124 and the second gate dielectric film 224 each include at least one of, for example, silicon oxide, silicon oxynitride, silicon nitride or a high dielectric constant material that has a dielectric constant greater than that of silicon oxide. The high dielectric constant material includes, for example, but is not necessarily limited to, at least one of hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}), or combinations thereof.

In some embodiments, a first interfacial film 122 is formed between the first active pattern 110 and the first gate dielectric film 124. The first interfacial film 122 surrounds the periphery of the first active pattern 110. The first interfacial film 122 includes an oxide of the first active pattern 110. For example, the first interfacial film 122 includes silicon oxide.

In some embodiments, a second interfacial film 222 is formed between the second active pattern 210 and the second gate dielectric film 224. The second interfacial film 222 surrounds the periphery of the second active pattern 210. The second interfacial film 222 includes an oxide of the second active pattern 210. For example, the second interfacial film 222 includes silicon oxide.

A semiconductor device according to some embodiments includes an NC (Negative Capacitance) FET that uses a negative capacitor. For example, the first gate dielectric film 124 or the second gate dielectric film 224 includes a ferroelectric material film that has ferroelectric properties, and a paraelectric material film that has paraelectric properties.

The ferroelectric material film has a negative capacitance, and the paraelectric material film has a positive capacitance. For example, if two or more capacitors are connected in series and the capacitance of each capacitor has a positive value, the overall capacitances decrease from the capacitance of each of the individual capacitors. On the other hand, if at least one capacitance of two or more series-connected capacitors has a negative value, the overall capacitance is a positive value that is greater than an absolute value of each of the individual capacitances.

When a negative capacitance ferroelectric material film and a positive capacitance paraelectric material film are connected in series, the overall capacitance of the series-connected ferroelectric material film and paraelectric material film increases. Due to the increased overall capacitance, a transistor that includes the ferroelectric material film has a subthreshold swing (SS) below 60 mV/decade at room temperature.

A ferroelectric material film has ferroelectric properties. The ferroelectric material film includes, for example, at least one of hafnium oxide, hafnium zirconium oxide, barium strontium titanium oxide, barium titanium oxide, or lead zirconium titanium oxide. For example, hafnium zirconium oxide is obtained by doping hafnium oxide with zirconium (Zr). For another example, hafnium zirconium oxide is a compound of hafnium (Hf), zirconium (Zr), and oxygen (O).

The ferroelectric material film further includes a dopant. For example, the dopant includes at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). The type of dopant in the ferroelectric material film can vary, depending on which type of ferroelectric material is in the ferroelectric material film.

When the ferroelectric material film includes hafnium oxide, the dopant i in the ferroelectric material film includes, for example, at least one of gadolinium (Gd), silicon (Si), zirconium (Zr), aluminum (Al), or yttrium (Y).

When the dopant is aluminum (Al), the ferroelectric material film includes 3 to 8 at% (atomic %) aluminum. A ratio of the dopant is a ratio of aluminum to the sum of hafnium and aluminum.

When the dopant is silicon (Si), the ferroelectric material film includes 2 to 10 at% silicon. When the dopant is yttrium (Y), the ferroelectric material film includes 2 to 10 at% yttrium. When the dopant is gadolinium (Gd), the ferroelectric material film includes 1 to 7 at% gadolinium. When the dopant is zirconium (Zr), the ferroelectric material film includes 50 to 80 at% zirconium.

A paraelectric material film has paraelectric properties. The paraelectric material film includes at least one of, for example, a silicon oxide or a metal oxide that has a high dielectric constant. The metal oxide in the paraelectric material film includes, for example, but is not necessarily limited to, at least one of hafnium oxide, zirconium oxide, or aluminum oxide.

The ferroelectric material film and the paraelectric material film may include the same material. The ferroelectric material film has ferroelectric properties, but the paraelectric material film does not have ferroelectric properties. For example, when the ferroelectric material film and the paraelectric material film each include hafnium oxide, a crystal structure of hafnium oxide in the ferroelectric material film differs from a crystal structure of hafnium oxide in the paraelectric material film.

The ferroelectric material film has a thickness that affects the ferroelectric properties. The thickness of the ferroelectric material film may be, for example, but is not necessarily limited to, 0.5 to 10 nm. Since a critical thickness that exhibits the ferroelectric properties can vary for each ferroelectric material, the thickness of the ferroelectric material film can vary depending on the ferroelectric material.

For example, the first gate dielectric film 124 and/or the second gate dielectric film 224 include one ferroelectric material film. For another example, the first gate dielectric film 124 and/or the second gate dielectric film 224 include a plurality of ferroelectric material films spaced apart from each other. The first gate dielectric film 124 and/or the second gate dielectric film 224 have a stacked film structure in which a plurality of ferroelectric material films and a plurality of paraelectric material films are alternately stacked.

The first gate electrode 130 is formed on the substrate 100 and the field insulating film 105. In addition, the first gate electrode 130 is stacked on the first gate dielectric film 124. For example, the first gate dielectric film 124 is interposed between the first active pattern 110 and the first gate electrode 130. In addition, the first gate dielectric film 124 is interposed between the first fin pattern 110F and the first gate electrode 130. The first gate electrode 130 may be formed through, for example, but is not necessarily limited to, a replacement process.

A second gate electrode 230 is formed on the substrate 100 and the field insulating film 105. In addition, the second gate electrode 230 is stacked on the second gate dielectric film 224. For example, the second gate dielectric film 224 is interposed between the second active pattern 210 and the second gate electrode 230. In addition, the second gate dielectric film 224 is interposed between the second fin pattern 210F and the second gate electrode 230. The second gate electrode 230 may be formed through, for example, but is not necessarily limited thereto, a replacement process.

Although each of the first gate electrode 130 and the second gate electrode 230 is shown as a single film, embodiments are not limited thereto, and in some embodiments, the first gate electrode 130 and the second gate electrode 230 are formed by stacking a plurality of conductive layers. For example, each of the first gate electrode 130 and the second gate electrode 230 includes a work function adjusting film that adjusts a work function, and a filling conductive film that fills a space formed by the work function adjusting film. The work function adjusting film includes, for example, but is not necessarily limited to, at least one of TiN, TaN, TiC, TaC, TiAlC, or combinations thereof. The filling conductive film includes, for example, but is not necessarily limited to, W or Al.

A first gate spacer 140 is formed on the substrate 100 and the field insulating film 105. The first gate spacer 140 extends along the side surfaces of the first gate electrode 130. In some embodiments, the first gate dielectric film 124 is interposed between the first gate electrode 130 and the first gate spacer 140. For example, the first gate dielectric film 124 further extends along at least a part of the inner side surface of the first gate spacer 140. The first gate dielectric film 124 may be formed by, but is not necessarily limited to, a replacement process.

A second gate spacer 240 is formed on the substrate 100 and the field insulating film 105. The second gate spacer 240 extends along the side surfaces of the second gate electrode 230. In some embodiments, the second gate dielectric film 224 is interposed between the second gate electrode 230 and the second gate spacers 240. For example, the second gate dielectric film 224 further extends along at least a part of the inner side surfaces of the second gate spacers 240. The second gate dielectric film 224 may be formed by, but is not necessarily limited to, a replacement process.

The first gate spacer 140 and the second gate spacer 240 each include, for example, at least one of silicon nitride, silicon oxynitride, silicon oxycarbide, silicon boron nitride, silicon boron carbonitride, silicon oxycarbonitride, or combinations thereof.

The first gate capping pattern 150 is formed on the first gate electrode 130. The first gate capping pattern 150 extends along the upper surface of the first gate electrode 130. In some embodiments, the first gate capping pattern 150 covers the upper surface of the first gate electrode 130 and the upper surface of the first gate spacer 140. In some embodiments, the upper surface of the first gate electrode 130 and the upper surface of the first gate spacer 140 include a concave surface that is recessed downward toward the substrate 100.

The second gate capping pattern 250 is formed on the second gate electrode 230. The second gate capping pattern 250 extends along the upper surface of the second gate electrode 230. In some embodiments, the second gate capping pattern 250 covers the upper surface of the second gate electrode 230 and the upper surface of the second gate spacers 240. In some embodiments, the upper surface of the second gate electrode 230 and the upper surface of the second gate spacer 240 include a concave surface that is recessed downward toward the substrate.

The first gate capping pattern 150 and the second gate capping pattern 250 each include, for example, at least one of silicon nitride, silicon oxynitride, silicon oxycarbide, silicon boron nitride, silicon boron carbonitride, silicon oxycarbonitride, or combinations thereof.

The first epitaxial pattern 160 is formed on the upper surface of the substrate 100 and at least one side surface, such as both side surfaces, of the first gate structure G1. In addition, the first epitaxial pattern 160 is connected to the first active pattern 110. For example, each of the first to third sheet patterns 111 to 113 penetrates the first gate structure G1 and is connected to the first epitaxial pattern 160. The first epitaxial pattern 160 is separated from the first gate electrode 130 by the first gate dielectric film 124 and/or the first gate spacer 140. The first epitaxial pattern 160 is provided as a source/drain regions of a transistor, such as a NFET, formed on the first region I.

The second epitaxial pattern 260 is formed on the upper surface of the substrate 100 and at least one side surface, such as both side surfaces, of the second gate structure G2. The second epitaxial pattern 260 is connected to the second active pattern 210. For example, each of the fourth to sixth sheet patterns 211 to 213 penetrate the second gate structure G2 and is connected to the second epitaxial pattern 260. The second epitaxial pattern 260 is separated from the second gate electrode 230 by the second gate dielectric film 224 and/or the second gate spacer 240. The second epitaxial pattern 260 is provided as source/drain region of a transistor, such as a PFET, formed on the second region II.

The first epitaxial pattern 160 and the second epitaxial pattern 260 each include an epitaxial layer. For example, each of the first epitaxial pattern 160 and the second epitaxial pattern 260 is formed by an epitaxial growth method.

When the first region I is an NFET region, the first epitaxial pattern 160 includes n-type impurities or impurities that prevent diffusion of the n-type impurities. For example, the first epitaxial pattern 160 includes at least one of P, Sb, As, or combinations thereof.

In some embodiments, first epitaxial pattern 160 includes the same material as first active pattern 110. For example, when the first active pattern 110 is a silicon pattern, the first epitaxial pattern 160 is also a silicon pattern.

In some embodiments, the first epitaxial pattern 160 includes a tensile stress material. For example, when the first active pattern 110 is a silicon pattern, the first epitaxial pattern 160 includes a material, such as silicon carbide (SiC), that has a smaller lattice constant than silicon (Si). The tensile stress material applies a tensile stress to the first active pattern 110 to improve carrier mobility of the channel region.

In some embodiments, at least a part of an upper surface 160U of the first epitaxial pattern 160 is lower than the uppermost part of the first active pattern 110. For example, at least a part of the upper surface 160U of the first epitaxial pattern 160 is lower than the upper surface of the uppermost sheet pattern, such as the third sheet pattern 113. For example, the first epitaxial pattern 160 is a source/drain region of a lowered form.

In some embodiments, the upper surface 160U of the first epitaxial pattern 160 includes a {111} crystal plane. For example, the upper surface 160U of the first epitaxial pattern 160 is one of a (1 1 1) plane, a (1 1 -1) plane, a (1 -1 1) plane, a (1 -1 -1) plane, a (-1 1 1) plane, a plane (-1 1 -1) plane, a (-1 -1 1) plane, or a (-1 -1 -1) plane.

In some embodiments, the upper surface 160U of the first epitaxial pattern 160 forms a V shape in a cross-section, such as along line A1-A1, that intersects the second direction Y1. For example, as shown in FIGS. 1 and 2, the upper surface 160U of the first epitaxial pattern 160 includes a first inclined surface 161 and a second inclined surface 162 that form a V shape. The first inclined surface 161 is adjacent to the first gate structure G1, and the second inclined surface 162 is spaced apart from the first gate structure G1. A height of the first inclined surface 161 decreases with increasing distance from the first gate structure G1, and a height of the second inclined surface 162 increases with increasing distance from the first gate structure G1. An intersection line between the first inclined surface 161 and the second inclined surface 162 extends in the second direction Y1. In some embodiments, each of the first inclined surface 161 and the second inclined surface 162 includes a {111} crystal plane.

In some embodiments, the first inclined surface 161 extends from the upper surface of the uppermost sheet pattern, such as the third sheet pattern 113. Accordingly, the lowermost part of the upper surface 160U of the first epitaxial pattern 160, such as the intersection line between the first inclined surface 161 and the second inclined surface 162, is lower than the uppermost part of the first active pattern 110.

In some embodiments, the first epitaxial pattern 160 has a hexagonal shape in a cross-section, such as along line C1-C1, that intersects the first direction X1. For example, as shown in FIGS. 1 and 5, the first epitaxial pattern 160 includes a first cross-section 160o and a second cross-section 160i that each have a hexagonal shape. The first cross-section 160o is adjacent to the first gate structure G1, and the second cross-section 160i is spaced from the first gate structure G1. The size of the second cross-section 160i is smaller than the size of the first cross-section 160o. For example, in a cross-section that intersects the first direction X1, the size of the first epitaxial pattern 160 decreases and then increases, with increasing distance from the first gate structure G1. Accordingly, the upper surface 160U of the first epitaxial pattern 160 has a V shape in a cross-section, such as along line A1-A1, that intersects the second direction Y1.

When the second region II is a PFET region, the second epitaxial pattern 260 includes p-type impurities or impurities that prevent diffusion of the p-type impurities. For example, the second epitaxial pattern 260 includes at least one of B, C, In, Ga, Al, or combinations thereof.

In some embodiments, the second epitaxial pattern 260 includes a compressive stress material. For example, when the second active pattern 210 is a silicon pattern, the second epitaxial pattern 260 includes a material, such as silicon germanium (SiGe), that has a larger lattice constant than silicon (Si). The compressive stress material applies a compressive stress to the second active pattern 210 to improve carrier mobility of the channel region.

In some embodiments, at least a part of an upper surface 260U of the second epitaxial pattern 260 is higher than the uppermost part of the second active pattern 210. For example, at least a part of the upper surface 260U of the second epitaxial pattern 260 is higher than the upper surface of the uppermost sheet pattern, such as the sixth sheet pattern 213. For example, the second epitaxial pattern 260 is provided as a source/drain region of an elevated/raised form.

In some embodiments, the second epitaxial pattern 260 has a pentagon shape in a cross-section, such as along line C2-C2, that intersects the fourth direction X2. The uppermost part of the second epitaxial pattern 260, such as an upper vertex of the pentagon, is higher than the upper surface of the uppermost sheet pattern, such as the sixth sheet pattern 213.

Since first epitaxial pattern 160 has a lowered shape, the first epitaxial pattern 160 is relatively small. For example, as shown in FIGS. 1 and 5, the height of the first epitaxial pattern 160 in the third direction Z1 is lower than the height of the second epitaxial pattern 260 in the sixth direction Z2. in addition, a length of the first epitaxial pattern 160 in the second direction Y1 is shorter than a length of the second epitaxial pattern 260 in the fifth direction Y2.

An interlayer insulating film 180 is formed on the substrate 100 and the field insulating film 105. The interlayer insulating film 180 fills the space on the side surface of the first gate structure G1 and the space on the side surface of the second gate structure G2. For example, the interlayer insulating film 180 covers the field insulating film 105, the first epitaxial pattern 160 and the second epitaxial pattern 260. Although the interlayer insulating film 180 is shown as exposing the upper surface of the first gate structure G1 and the upper surface of the second gate structure G2, embodiments are not necessarily limited thereto. For example, in other embodiments, the interlayer insulating film 180 covers the upper surface of the first gate structure G1 and the upper surface of the second gate structure G2.

The interlayer insulating film 180 includes, for example, but is not necessarily limited to, at least one of silicon oxide, silicon nitride, silicon oxynitride, silicon oxycarbide, silicon boron nitride, silicon boron carbonitride, silicon oxycarbonitride, or a low dielectric constant material that has a lower dielectric constant than silicon oxide. The low dielectric constant material includes, for example, at least one of FOX (Flowable Oxide), TOSZ (Torene SilaZene), USG (Undoped Silica Glass), BSG (Borosilica Glass), PSG (PhosphoSilica Glass), BPSG (BoroPhosphoSilica Glass), PETEOS (Plasma Enhanced Tetra Ethyl Ortho Silicate), FSG (Fluoride Silicate Glass), CDO (Carbon Doped silicon Oxide), Xerogel, Aerogel, Amorphous Fluorinated Carbon, OSG (Organo Silicate Glass), Parylene, BCB (bis-benzocyclobutenes), SiLK, polyimide, porous polymeric material, or combinations thereof.

In some embodiments, a first liner film 182 covers the first epitaxial pattern 160 and the second epitaxial pattern 260. The first liner film 182 conformally extends along profiles of a surface of the first epitaxial pattern 160 and a surface of the second epitaxial pattern 260. The first liner film 182 further extends along the upper surface of the field insulating film 105, the side surfaces of the first gate structure G1, and the side surfaces of the second gate structure G2. The interlayer insulating film 180 is formed on the first liner film 182.

The first liner film 182 includes a material that has an etch selectivity with respect to the interlayer insulating film 180. For example, when the interlayer insulating film 180 includes silicon oxide, the first liner film 182 includes at least one of silicon nitride (SiN), silicon oxynitride (SiON), silicon oxycarbonitride (SiOCN), silicon boronitride (SiBN), silicon oxyboronitride (SiOBN), silicon oxycarbide (SiOC), or combinations thereof. The first liner film 182 serves an etch stop layer in an etching process for the interlayer insulating film 180.

The first source/drain contact CA1 penetrates the upper surface 160U of the first epitaxial pattern 160, and is connected to the first epitaxial pattern 160. For example, a first contact hole HC1 is formed that extends in a third direction Z1 that intersects the first direction X1 and the second direction Y1. The first contact hole HC1 penetrates the interlayer insulating film 180 and the first liner film 182 and exposes the first source/drain contact CA1. The first source/drain contact CA1 is formed in the first contact hole HC1 and is connected to the first epitaxial pattern 160.

In some embodiments, the first source/drain contact CA1 intersects a lowermost part, such as an intersection line between the first inclined surface 161 and the second inclined surface 162, of the upper surface 160U of the first epitaxial pattern 160.

The second source/drain contact CA2 penetrates the upper surface 260U of the second epitaxial pattern 260, and is connected to the second epitaxial pattern 260. For example, a second contact hole HC2 is formed that extends in a sixth direction Z2 that intersects the fourth direction X2 and the fifth direction Y2. The second contact hole HC2 penetrates the interlayer insulating film 180 and the first liner film 182 and exposes the second source/drain contact CA2. The second source/drain contact CA2 is formed in the second contact hole HC2 and is connected to the second epitaxial pattern 260.

In some embodiments, the second source/drain contact CA2 intersects the uppermost part of the second epitaxial pattern 260, such as an upper vertex of a pentagon.

An intersection point between the upper surface 160U of the first epitaxial pattern 160 and the side surface of the first source/drain contact CA1 are lower than an intersection point between the upper surface 260U of the second epitaxial pattern 260 and the side surface of the second source/drain contact CA2. Accordingly, the lower surface of the first source/drain contact CA1 is lower than the lower surface of the second source/drain contact CA2. For example, based on the upper surface of the substrate 100, a height H1 of the lower surface of the first source/drain contact CA1 is less than a height H2 of the lower surface of the second source/drain contact CA2. For example, the second source/drain contact CA2 is shallower than the first source/drain contact CA1.

In some embodiments, slopes of the side surfaces of the first source/drain contact CA1 in the first epitaxial pattern 160 less steep than slopes of the side surfaces of the first source/drain contact CA1 in the interlayer insulating film 180. For example, as shown in FIG. 3A, a first acute angle θ11 formed between the side surface of the first source/drain contact CA1 in the first epitaxial pattern 160 and the upper surface of the substrate 100 is smaller than a second acute angle θ12 formed between the side surface of the first source/drain contact CA1 in the interlayer insulating film 180 and the upper surface of the substrate 100.

In some embodiments, slopes of the side surfaces of the second source/drain contacts CA2 in the second epitaxial pattern 260 are less steep than slopes of the side surfaces of the second source/drain contacts CA2 in the interlayer insulating film 180. For example, as shown in FIG. 3B, a third acute angle θ21 formed between the side surface of the second source/drain contact CA2 in the second epitaxial pattern 260 and the upper surface of the substrate 100 is less than a fourth acute angle θ22 formed between the side surface of the second source/drain contact CA2 in the interlayer insulating film 180 and the upper surface of the substrate 100.

Although the first acute angle θ11 is shown as being equal to the third acute angle θ21, embodiments are not necessarily limited thereto. In some embodiments, the first acute angle θ11 and the third acute angle θ21 differ from each other, depending on the characteristics of the etching process that forms the first contact hole HC1 and/or the second contact hole HC2.

In addition, a first depth D1 from the intersection point between the upper surface 160U of the first epitaxial pattern 160 and the side surface of the first source/drain contact CA1 to the lower surface of the first source/drain contact CA1 is equal to a second depth D2 from the intersection point between the upper surface 260U of the second epitaxial pattern 260 and the side surfaces of the second source/drain contact CA2 to the lower surface of the second source/drain contact CA2, however, embodiments are not necessarily limited thereto. In some embodiments, the first depth D1 and the second depth D2 differ from each other, depending on the characteristics of the etching process that forms the first contact hole HC1 and/or the second contact hole HC2.

In some embodiments, the first source/drain contact CA1 includes a first silicide film 192, a first barrier metal film 194, and a first metal film 196 that are sequentially stacked on the first epitaxial pattern 160. In some embodiments, the second source/drain contact CA2 includes a second silicide film 292, a second barrier metal film 294, and a second metal film 296 that are sequentially stacked on the second epitaxial pattern 260.

The first silicide film 192 is interposed between the first epitaxial pattern 160 and the first barrier metal film 194, and the second silicide film 292 is interposed between the second epitaxial pattern 260 and the second barrier metal film 294. Each of the first silicide film 192 and the second silicide film 292 includes, but is not necessarily limited to, a metal silicide such as nickel silicide, cobalt silicide, tungsten silicide, titanium silicide, niobium silicide or tantalum silicide. For example, the first silicide film 192 and the second silicide film 292 each include titanium silicide.

The first barrier metal film 194 is formed on the first silicide film 192. The first barrier metal film 194 conformally extends along the profile of the first contact hole HC1. The second barrier metal film 294 is formed on the second silicide film 292. The second barrier metal film 294 conformally extends along the profile of the second contact hole HC2. Each of the first barrier metal film 194 and the second barrier metal film 294 includes, for example, but is not necessarily limited to, conductive metal nitrides such as titanium nitride, tantalum nitride or tungsten nitride. For example, the first barrier metal film 194 and the second barrier metal film 294 each include titanium nitride.

The first metal film 196 is formed on the first barrier metal film 194. The first metal film 196 fills a region of the first contact hole HC1 that remains after the first barrier metal film 194 is formed. The second metal film 296 is formed on the second barrier metal film 294. The second metal film 296 fills a region of the second contact hole HC2 that remains after the second barrier metal film 294 is formed. Each of the first metal film 196 and the second metal film 296 includes, for example, but is not necessarily limited to, a metal such as cobalt (Co), titanium (Ti), tantalum (Ta), ruthenium (Ru), tungsten (W) or cobalt tungsten phosphorus (CoWP). For example, the first metal film 196 and the second metal film 296 each include cobalt (Co).

In some embodiments, the first source/drain contact CA1 and the second source/drain contact CA2 are formed at the same level. In this specification, the expression "formed at the same level" means formation by the same fabricating process. For example, the first barrier metal film 194 and the first metal film 196 are each made of the same material and the same material configuration as those of the second barrier metal film 294 and the second metal film 296.

In some embodiments, the first silicide film 192 is formed by reaction of elements contained in the first barrier metal film 194 with the first epitaxial pattern 160, and the second silicide film 292 is formed by reaction of elements included in the second barrier metal film 294 with the second epitaxial pattern 260.

In some embodiments, the first silicide film 192 extends along the lower surface of the first barrier metal film 194 but does not extend along the side surfaces of the first barrier metal film 194. Similarly, the second silicide film 292 extends along the lower surface of the second barrier metal film 294 but does not extend along the side surfaces of the second barrier metal film 294.

For example, the first barrier metal film 194 and the second barrier metal film 294 are each formed by a physical vapor deposition (PVD). In a physical vapor deposition process, the first epitaxial pattern 160 adjacent to the lower surface of the first barrier metal film 194 forms the first silicide film 192, and the second epitaxial pattern 260 adjacent to the lower surface of the second barrier metal film 294 forms the second silicide film 292.

In some embodiments, a second liner film 184 is formed on the interlayer insulating film 180 and the first liner film 182. The second liner film 184 conformally extends along the profiles of the side surfaces of the first source/drain contact CA1 and the side surfaces of the second source/drain contact CA2.

The second liner film 184 includes, for example, at least one of silicon oxide, silicon nitride, silicon oxynitride, silicon oxycarbide, silicon boron nitride, silicon boron carbonitride, silicon oxycarbonitride, or a low-dielectric film material that has a lower dielectric constant than silicon oxide.

To increase performance of a PFET, a source/drain region, such as an epitaxial pattern, that applies a compressive stress to the channel of PFET can be used. For example, when the channel of a PFET is a silicon pattern, the source/drain region of PFET is a silicon germanium (SiGe) pattern, which has a lattice constant larger than silicon (Si). However, due to the relatively low bonding energy between silicon (Si) and germanium (Ge), in an etching process that forms a contact connected to the source/drain region, hereinafter referred to as source/drain contact, the source/drain region of PFET can be excessively etched. For example, in the etching process that forms the source/drain contact, the source/drain region of the PFET that includes the silicon germanium (SiGe) pattern is etched deeper than the source/drain region of the NFET that includes the silicon (Si) pattern. As a result, a stress caused by the source/drain region of the PFET is reduced, and the performance of the semiconductor device can deteriorate.

However, as described above, in a semiconductor device according to some embodiments, the first epitaxial pattern 160 disposed in the source/drain region of the NFET has a relatively lowered form, and the second epitaxial pattern 260 disposed in the source/drain region of the PFET has a relatively elevated form. Accordingly, even if the first source/drain contact CA1 and the second source/drain contact CA2 are formed at the same level, the second source/drain contact CA2 is shallower than the first source/drain contact CA1. As a result, the stress caused by the second epitaxial pattern 260 is efficiently maintained, and a semiconductor device that has increased performance is provided.

In addition, as described above, in a semiconductor device according to some embodiments, since the first source/drain contact CA1 is relatively deep, a contact area with the first epitaxial pattern 160 is increased. Accordingly, a contact resistance between the first epitaxial pattern 160 and the first source/drain contact CA1 is reduced, and a semiconductor device that has increased performance is provided.

In addition, as described above, in a semiconductor device according to some embodiments, since the first epitaxial pattern 160 has a lowered form and is relatively small, an area opposite to the first gate electrode 130 is reduced. Accordingly, a parasitic capacitance between the first epitaxial pattern 160 and the first gate electrode 130 is reduced, and a semiconductor device that has increased performance is provided.

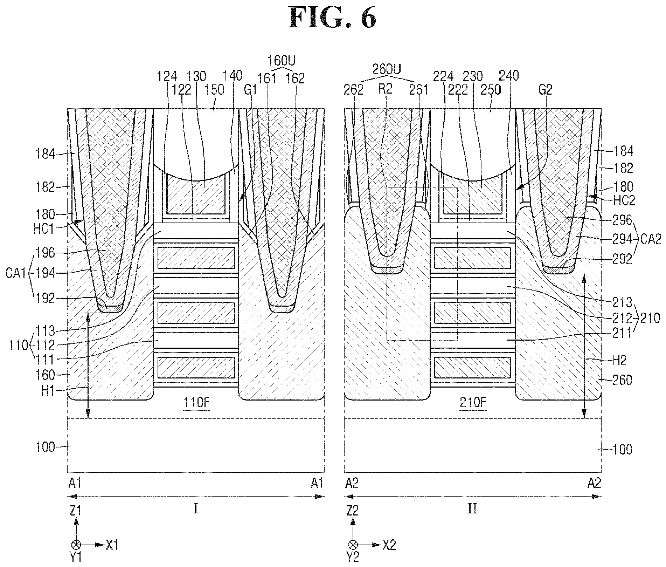

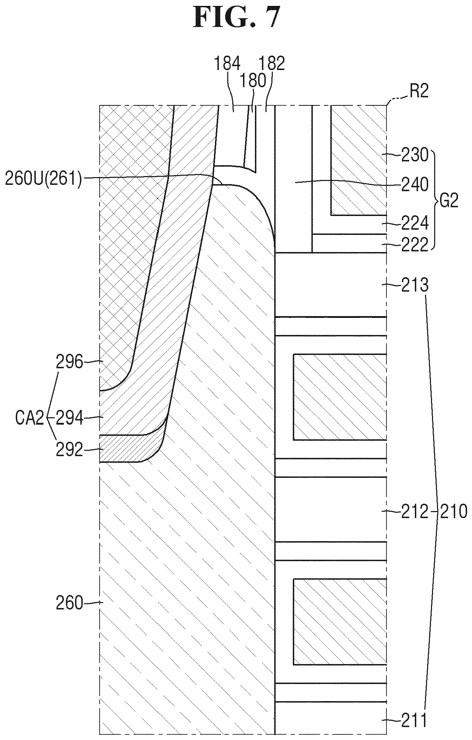

FIG. 6 is another cross-sectional view taken along lines A1-A1 and A2-A2 of FIG. 1. FIG. 7 is an enlarged view of a region R1 and a region R2 of FIG. 6. For convenience of description, descriptions of components described above using FIGS. 1 to 5 will be summarized or omitted.

Referring to FIGS. 6 and 7, in a semiconductor device according to some embodiments, the upper surface 260U of the second epitaxial pattern 260 has a convex shape which protrudes upward in a cross-section taken along line A2-A2 that intersects the fifth direction Y2.

For example, the upper surface 260U of the second epitaxial pattern 260 includes a first convex surface 261 and a second convex surface 262, as shown. The first convex surface 261 is adjacent to the second gate structure G2, and the second convex surface 262 is spaced apart from the second gate structure G2 in the fourth direction X2. A height of the first convex surface 261 increases with increasing distance from the first gate structure G1, and a height of the second convex surface 262 decreases with increasing distance from the first gate structure G1.

In some embodiments, the first convex surface 261 is interposed between the second gate structure G2 and the second source/drain contact CA2.

In some embodiments, the first convex surface 261 extends from the upper surface of the uppermost sheet pattern, such as the sixth sheet pattern 213. Accordingly, the uppermost part of the upper surface 260U of the second epitaxial pattern 260 is higher than the uppermost part of the second active pattern 210.

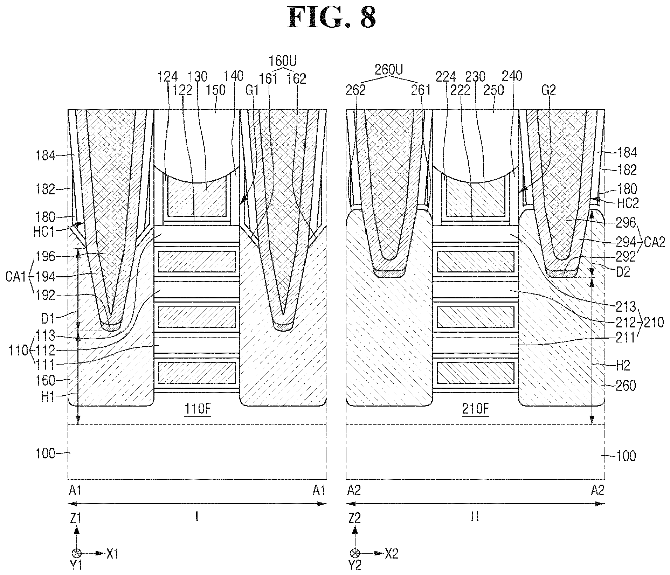

FIGS. 8 to 10 are various other cross-sectional views taken along lines A1-A1 and A2-A2 of FIG. 1. For convenience of description, descriptions of components described above using FIGS. 1 to 7 will be summarized or omitted.

Referring to FIG. 8, in a semiconductor device according to some embodiments, a first depth D1 from the intersection point between the upper surface 160U of the first epitaxial pattern 160 and the side surface of the first source/drain contact CA1 to the lower surface of the first source/drain contact CA1 is greater than a second depth D2 from the intersection point between the upper surface 260U of the second epitaxial pattern 260 and the side surface of the second source/drain contact CA2 to the lower surface of the second source/drain contact CA2.

This difference may be due to characteristics of the etching process that forms the first contact hole HC1 and the second contact hole HC2. For example, unlike the upper surface 260U of the second epitaxial pattern 260, since the upper surface 160U of the first epitaxial pattern 160 has a V shape, the first epitaxial pattern 160 can be more easily etched in the etching process.

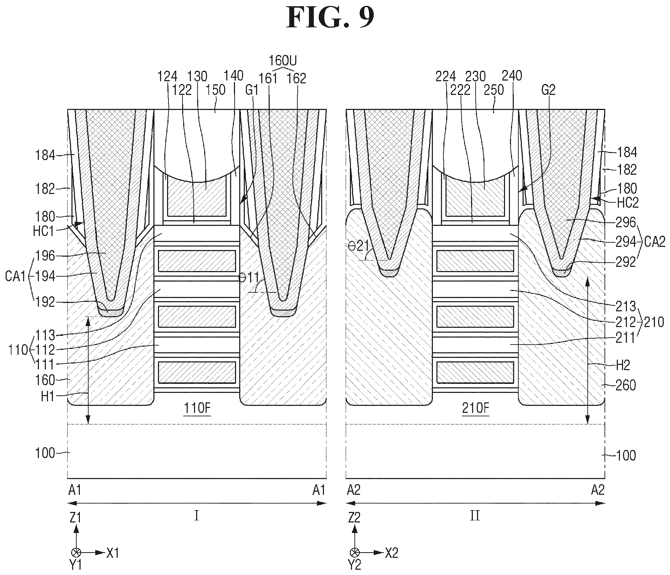

Referring to FIG. 9, in an semiconductor device according to some embodiments, the third acute angle θ21 formed between the side surface of the second source/drain contact CA2 in the second epitaxial pattern 260 and the upper surface of the substrate 100 is greater than the first acute angle θ11 formed between the side surface of the first source/drain contact CA1 in the first epitaxial pattern 160 and the upper surface of the substrate 100.

This difference may be due to characteristics of the etching process that forms the first contact hole HC1 and the second contact hole HC2. For example, unlike the upper surface 260U of the second epitaxial pattern 260, since the upper surface 160U of the first epitaxial pattern 160 has a V shape, the first epitaxial pattern 160 can be more easily etched in the etching process.

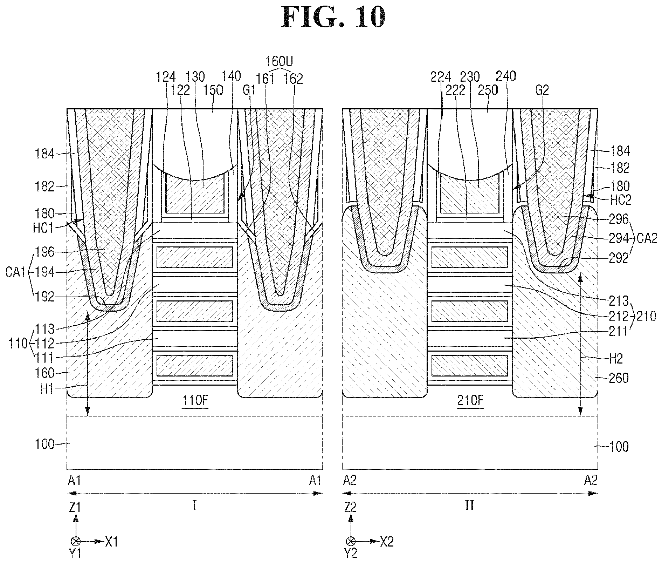

Referring to FIG. 10, in a semiconductor device according to some embodiments, the first silicide film 192 extends along the lower surface and side surfaces of the first barrier metal film 194. In addition, the second silicide film 292 extends along the lower surface and side surfaces of the second barrier metal film 294.

For example, the first barrier metal film 194 and the second barrier metal film 294 are each formed by a chemical vapor deposition (CVD). In a chemical vapor deposition process, the first epitaxial pattern 160 adjacent to the lower surface and side surfaces of the first barrier metal film 194 forms the first silicide film 192, and the second epitaxial pattern 260 adjacent to the lower surface and side surfaces of the second barrier metal film 294 forms the second silicide film 292.

For example, a contact area between the first epitaxial pattern 160 and the first silicide film 192 is increased, and a contact area between the second epitaxial pattern 260 and the second silicide film 292 is increased. Accordingly, a contact resistance between the first epitaxial pattern 160 and the first source/drain contact CA1, and a contact resistance between the second epitaxial pattern 260 and the second source/drain contact CA2 are reduced, and a semiconductor device with further increased performance is provided.

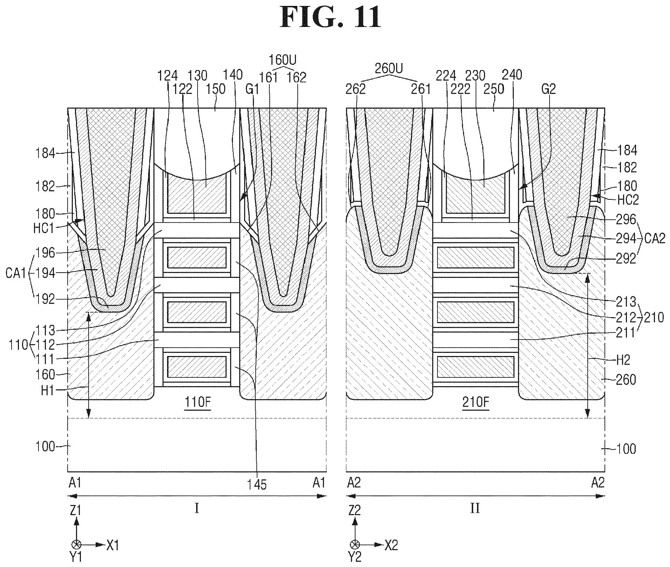

FIG. 11 is another cross-sectional view taken along lines A1-A1 and A2-A2 of FIG. 1. For convenience of description, descriptions of components described above using FIGS. 1 to 10 will be summarized or omitted.

Referring to FIG. 11, in a semiconductor device according to some embodiments, the first gate structure G1 further includes inner spacers 145.

The inner spacers 145 are formed on the side surfaces of the first gate electrode 130 between the first to third sheet patterns 111 to 113. In addition, the inner spacer 145 are formed on the side surfaces of the first gate electrode 130 between the first fin pattern 110F and the first sheet pattern 111. The first gate electrode 130 between the first to third sheet patterns 111 to 113 is separated from the first epitaxial pattern 160 by the first gate dielectric film 124 and/or the inner spacers 145.

The inner spacers 145 include, for example, but are not necessarily limited to, at least one of silicon nitride, silicon oxynitride, silicon oxycarbide, silicon boronitride, silicon boron carbonitride, silicon oxycarbonitride, or combinations thereof. The inner spacers 145 may include the same material as the first gate spacers 140 or may include different materials from the first gate spacers 140. Although the thickness of the inner spacers 145 is shown to equal to the thickness of the first gate spacers 140, embodiments are not necessarily limited thereto.

A method for fabricating a semiconductor device according to embodiments will be described below with reference to FIGS. 1 to 27.

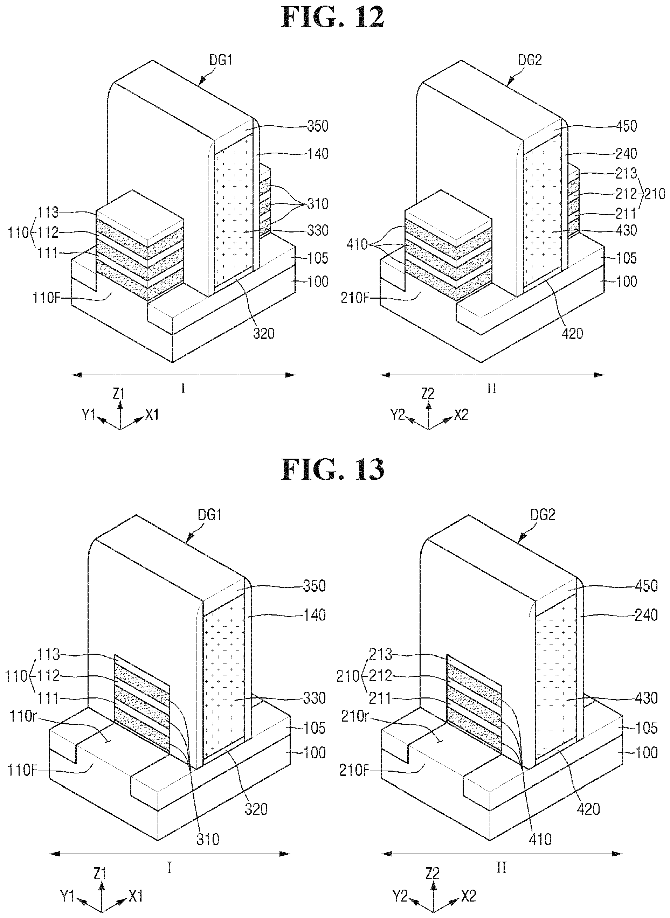

FIGS. 12 to 25 illustrate intermediate steps of a method for fabricating the semiconductor device according to some embodiments. For convenience of description, descriptions of components described above using FIGS. 1 to 11 will be summarized or omitted.

Referring to FIG. 12, in an embodiment, the first active pattern 110, as first sacrificial pattern 310 and a first dummy gate structure DG1 are formed on the first region I of the substrate 100, and the second active pattern 210, a second sacrificial pattern 410, and a second dummy gate structure DG2 are formed on the second region II of the substrate 100.

For example, a first material film and a second material film are formed that are alternately stacked on the first region I and the second region II of the substrate 100. Subsequently, a patterning process is performed on the first material film and the second material film.

The first material film patterned in the first region I forms the first sacrificial pattern 310, and the second material film patterned in the first region I forms first to third sheet patterns 111 to 113 that are alternately stacked with the first sacrificial pattern 310. In addition, the first material film patterned in the second region II forms the second sacrificial pattern 410, and the second material film patterned in the second region II forms fourth to sixth sheet patterns 211 to 213 that are alternately stacked with the second sacrificial pattern 410.

The sheet patterns 111 to 113 and 211 to 213 and the sacrificial patterns 310 and 410 have different etch selectivities. For example, the sheet patterns 111 to 113 and 211 to 213 each include silicon (Si), and the sacrificial patterns 310 and 410 each include silicon germanium (SiGe).

In some embodiments, a part of the substrate 100 is etched to form a first fin pattern 110F and a second fin pattern 210F while patterning the first and second material films. The field insulating film 105 is then formed on the substrate 100. The field insulating film 105 covers at least a part of the side surface of the first fin pattern 110F and at least a part of the side surface of the second fin pattern 210F.

The first dummy gate structure DG1 is formed on the first active pattern 110 and the first sacrificial pattern 310, and the second dummy gate structure DG2 is formed on the second active pattern 210 and the second sacrificial pattern 410.

The first dummy gate structure DG1 and the second dummy gate structure DG2 each extend along the upper surface of the substrate 100 and the upper surface of the field insulating film 105. The first dummy gate structure DG1 intersects the first active pattern 110. For example, the first dummy gate structure DG1 extends in the second direction Y1. The second dummy gate structure DG2 intersects the second active pattern 210. For example, the second dummy gate structure DG2 extends in the fifth direction Y2.

In some embodiments, the first dummy gate structure DG1 includes a first dummy gate dielectric film 320, a first dummy gate electrode 330, and a first gate spacer 140. In addition, the second dummy gate structure DG2 includes a second dummy gate dielectric film 420, a second dummy gate electrode 430, and a second gate spacer 240. For example, a dielectric film and an electrode film are formed that are sequentially stacked on the substrate 100 and the field insulating film 105. A first mask pattern 350 that extends in the second direction Y1 is formed on the electrode film on the first region I. In addition, a second mask pattern 450 that extends in the fifth direction Y2 is formed on the electrode film on the second region II. A patterning process is performed on the dielectric film and the electrode film using the first mask pattern 350 and the second mask pattern 450 as etching masks.

The dielectric film patterned in the first region I forms a first dummy gate dielectric film 320, and the electrode film patterned in the first region I forms a first dummy gate electrode 330. In addition, the dielectric film patterned in the second region II forms a second dummy gate dielectric film 420, and the electrode film patterned in the second region II forms a second dummy gate electrode 430.

The first dummy gate structure DG1 and the second dummy gate structure DG2 have different etching selectivities from the sheet patterns 111 to 113 and 211 to 213 and the sacrificial patterns 310 and 410. For example, the first dummy gate electrode 330 and the second dummy gate electrode 430 each include polysilicon.

The first gate spacer 140 is formed on the substrate 100 and the field insulating film 105. The first gate spacer 140 extends along the side surfaces of the first dummy gate structure DG1. The second gate spacer 240 is formed on the substrate 100 and the field insulating film 105. The second gate spacers 240 extends along the side surfaces of the second dummy gate structure DG2.

Referring to FIG. 13, in an embodiment, a first recess process is performed on the sheet patterns 111 to 113 and 211 to 213 and the sacrificial patterns 310 and 410.

As the first recess process is performed, some of the first to third sheet patterns 111 to 113 and some of the first sacrificial patterns 310 disposed outside the first dummy gate structure DG1 are removed to form a first recess 110r. In some embodiments, the upper part of the first fin pattern 110F is removed in the process of forming the first recess 110r.

In addition, as the first recess process is performed, some of the fourth to sixth sheet patterns 211 to 213 and some of the second sacrificial patterns 410 disposed outside the second dummy gate structure DG2 are removed to form a second recess 210r. In some embodiments, the upper part of the second fin pattern 210F is removed in the process of forming the second recess 210r.

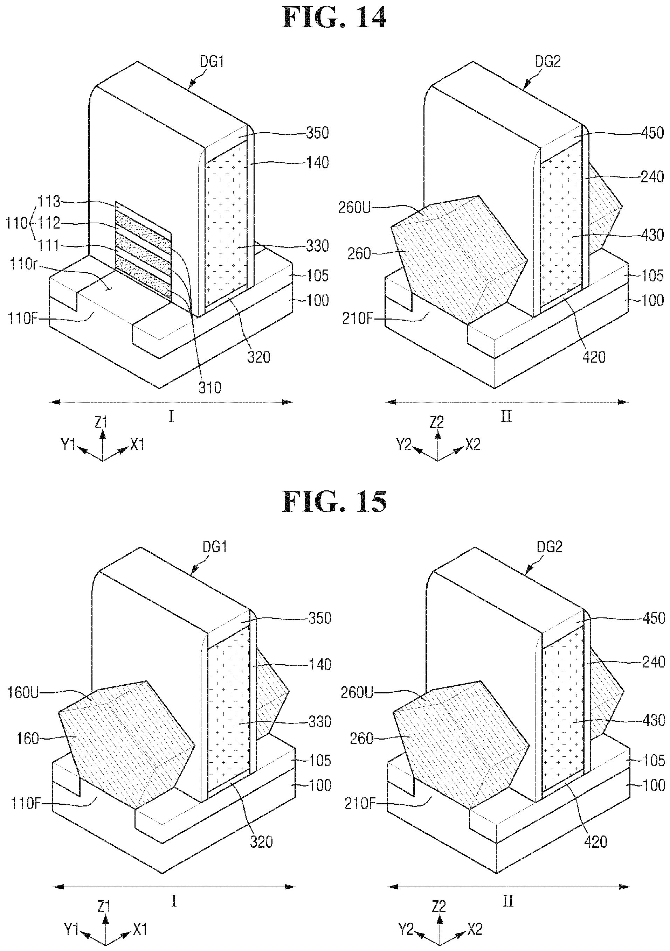

Referring to FIG. 14, in an embodiment, the second epitaxial pattern 260 is formed on the side surface of the second dummy gate structure DG2.

The second epitaxial pattern 260 fills the second recess 210r of FIG. 13. For example, the second epitaxial pattern 260 is formed by an epitaxial growth method that uses the second fin pattern 210F and the second active pattern 210 as seed layers. Accordingly, the second epitaxial pattern 260 connected to the second active pattern 210 is formed.

In some embodiments, at least a part of the upper surface 260U of the second epitaxial pattern 260 is formed to be higher than the uppermost part of the second active pattern 210. For example, the second epitaxial pattern 260 is formed in an elevated/raised form. In some embodiments, the second epitaxial pattern 260 has a pentagon shape in a cross-section, such as along line C2-C2 that intersects the fourth direction X2.

Referring to FIG. 15, in an embodiment, the first epitaxial pattern 160 is formed on the side surfaces of the first dummy gate structure DG1.

The first epitaxial pattern 160 fills the first recesses 1 10r of FIG. 13. For example, the first epitaxial pattern 160 is formed by an epitaxial growth method that uses the first fin pattern 110F and the first active pattern 110 as seed layers. Accordingly, the first epitaxial pattern 160 connected to the first active pattern 110 is formed.

In some embodiments, at least a part of the upper surface 260U of the first epitaxial pattern 160 is formed to be higher than the uppermost part of the first active pattern 110. For example, the first epitaxial pattern 160 is formed in an elevated/raised form. In some embodiments, the first epitaxial pattern 160 has a pentagon shape in a cross-section, such as along line C2-C2 that intersects the fourth direction X2.

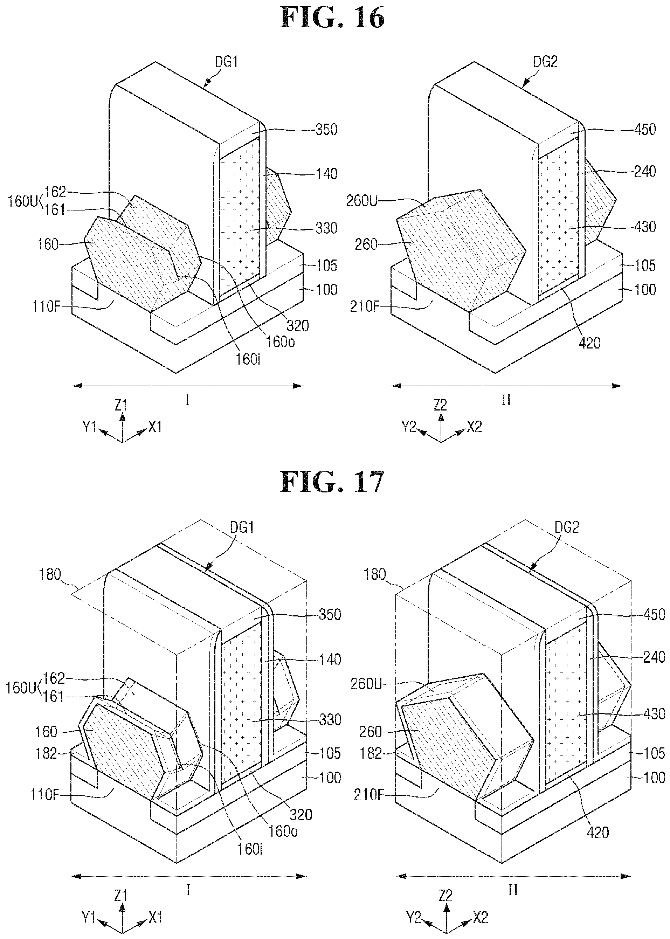

Referring to FIG. 16, in an embodiment, a lowered form first epitaxial pattern 160 is formed.

For example, an etchback process is performed on the first epitaxial pattern 160. Accordingly, the upper surface 160U of the first epitaxial pattern 160 is formed with a V shape in a cross-section, such as along line A1-A1 that intersects the second direction Y1.

The etchback process may be performed in-situ or ex-situ with the epitaxial growth process. In some embodiments, the lowered form first epitaxial pattern 160 is formed by repeatedly performing the epitaxial growth process and the etchback process.

In some embodiments, the upper surface 160U of the first epitaxial pattern 160 exposes a {111} crystal plane. For example, each of the first inclined surface 161 and the second inclined surface 162 includes the {111} crystal plane. For example, the epitaxial growth process has a limited duration, and the lowered form first epitaxial pattern 160 is formed.

Although the first epitaxial pattern 160 is described as being formed after the second epitaxial pattern 260 is formed, embodiments are not necessarily limited thereto. In some embodiments, the first epitaxial pattern 160 is formed before forming the second epitaxial pattern 260.

Referring to FIG. 17, in an embodiment, a first liner film 182 and an interlayer insulating film 180 are formed.

The first liner film 182 conformally extends along the surface profiles of the first epitaxial pattern 160 and the second epitaxial pattern 260. The first liner film 182 further extends along the upper surface of the field insulating film 105, the side surfaces of the first dummy gate structure DG1, and the side surfaces of the second dummy gate structure DG2. The interlayer insulating film 180 is formed on the first liner film 182.

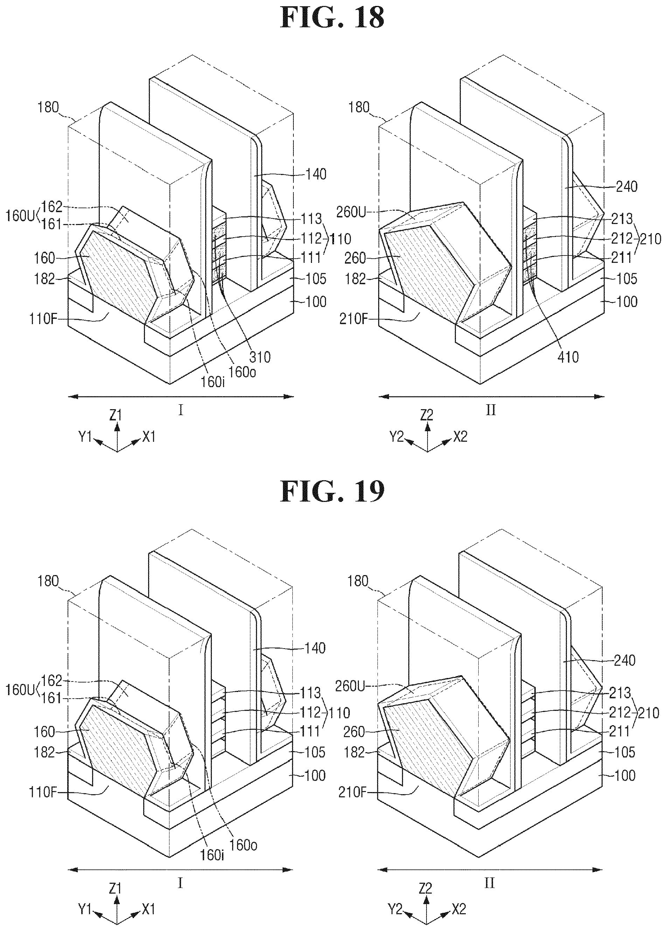

Referring to FIG. 18, in an embodiment, the first dummy gate dielectric film 320, the first dummy gate electrode 330, the second dummy gate dielectric film 420 and the second dummy gate electrode 430 are removed.

As described above, since the first dummy gate structure DG1 and the second dummy gate structure DG2 have different etch selectivities from the sheet patterns 111 to 113 and 211 to 213 and the sacrificial patterns 310 and 410, the first dummy gate structure DG1 and the second dummy gate structure DG2 are selectively removed. Since the first dummy gate structure DG1 is removed, the first active pattern 110 and the first sacrificial pattern 310 disposed inside the first gate spacer 140 is exposed. In addition, since the second dummy gate structure DG2 is removed, the second active pattern 210 and the second sacrificial pattern 410 disposed inside the second gate spacer 240 is exposed.

Referring to FIG. 19, in an embodiment, the first sacrificial pattern 310 and the second sacrificial pattern 410 are removed.

As described above, since the sheet patterns 111 to 113 and 211 to 213 and the sacrificial patterns 310 and 410 have different etch selectivities, the first sacrificial pattern 310 and the second sacrificial pattern 410 are selectively removed. Since the first sacrificial pattern 310 and the second sacrificial pattern 410 are removed, the first active patterns 110 that are spaced apart from each other are formed on the first region I of the substrate 100, and the second active patterns 210 that are spaced apart from each other are formed on the second regions II of the substrate 100.

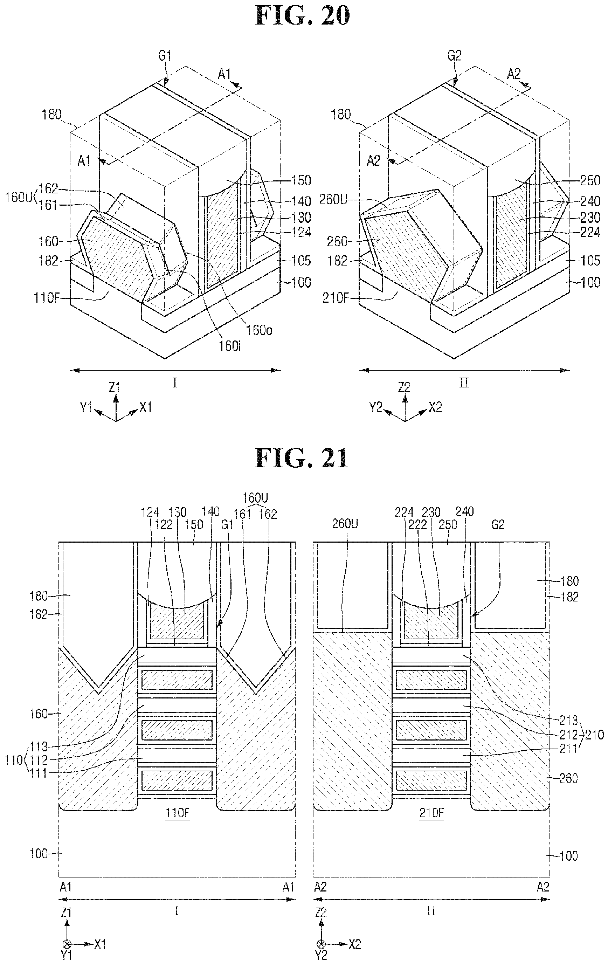

Referring to FIGS. 20 and 21, in an embodiment, a first gate structure G1 and a second gate structure G2 are formed. For reference, FIG. 21 is a cross-sectional view taken along lines A1-A1 and A2-A2 of FIG. 20.

For example, the first gate dielectric film 124 and the first gate electrode 130 are sequentially stacked on the first active pattern 110, and the second gate dielectric film 224 and the second gate electrode 230 are sequentially stacked on the second active pattern 210. A first gate capping pattern 150 is formed on the first gate electrode 130, and a second gate capping pattern 250 is formed on the second gate electrode 230. In some embodiments, the first gate capping pattern 150 and the second gate capping pattern 250 are formed after the etchback process is performed on the first gate electrode 130 and the second gate electrode 230.

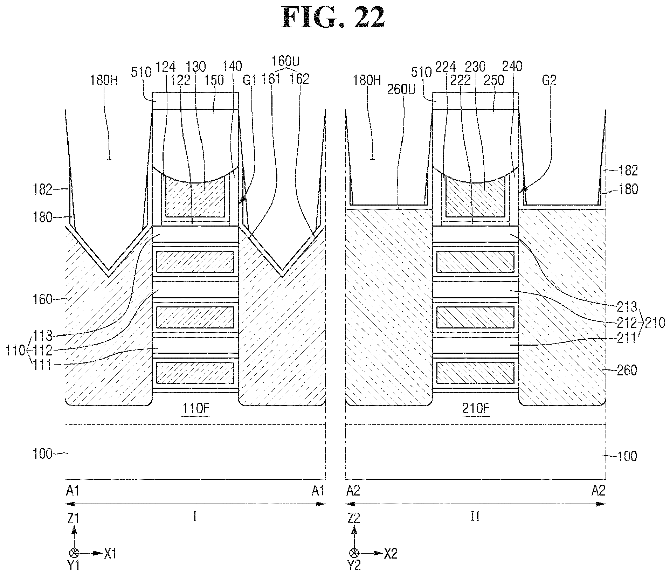

Referring to FIG. 22, in an embodiment, a preliminary contact hole 180H is formed inside the interlayer insulating film 180.

For example, a third mask pattern 510 is formed on the first gate capping pattern 150 and the second gate capping pattern 250. An etching process is performed on the interlayer insulating film 180 using the third mask pattern 510 as an etching mask. Accordingly, the preliminary contact hole 180H is formed on the first epitaxial pattern 160 and the second epitaxial pattern 260.

The first liner film 182 is provided as an etch stop layer for the etching process on the interlayer insulating film 180. For example, the preliminary contact hole 180H exposes the first liner film 182 that extends along the upper surface 160U of the first epitaxial pattern 160 and the upper surface 260U of the second epitaxial pattern 260.

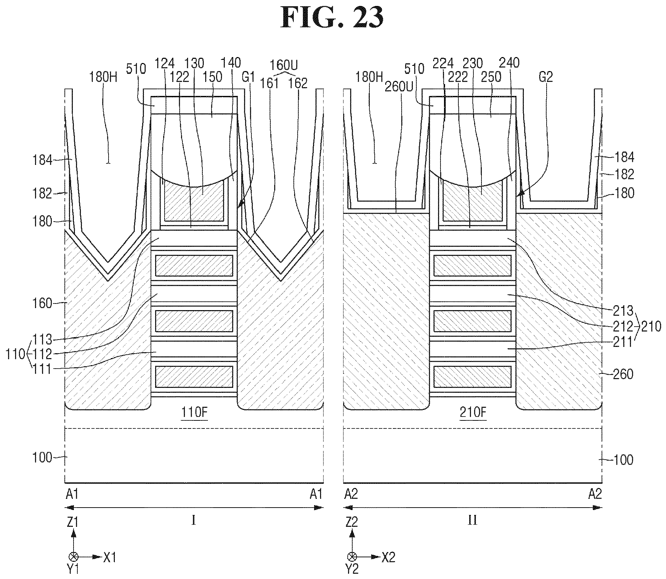

Referring to FIG. 23, in an embodiment, a second liner film 184 is formed on the interlayer insulating film 180 and the first liner film 182.

The second liner film 184 is formed in the first contact hole HC1 and the second contact hole HC2. For example, the second liner film 184 conformally extends along the surface profiles of the interlayer insulating film 180 and the first liner film 182.

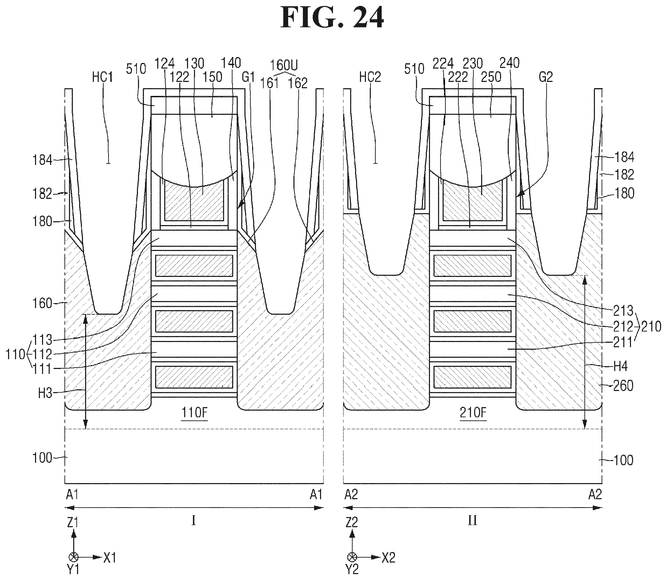

Referring to FIG. 24, in an embodiment, a first contact hole HC1 is formed that extends in the third direction Z1 and a second contact hole HC2 is formed that extends in the sixth direction Z2.

The first contact hole HC1 penetrates the interlayer insulating film 180, the first liner film 182 and the second liner film 184 and exposes the first source/drain contact CA1. The second contact hole HC2 penetrates the interlayer insulating film 180, the first liner film 182 and the second liner film 184 and exposes the second source/drain contact CA2. In some embodiments, the first contact hole HC1 and the second contact hole HC2 are formed at the same level or at the same time.

As described above, the lowered form first epitaxial pattern 160 is formed, and the elevated form second epitaxial pattern 260 is formed. Therefore, the lower surface of the first contact hole HC1 is formed lower than the lower surface of the second contact hole HC2. For example, based on the upper surface of the substrate 100, a height H3 of the lower surface of the first contact hole HC1 is less than a height H4 of the lower surface of the second contact hole HC2. For example, the second contact hole HC2 is shallower than the first contact hole HC1.

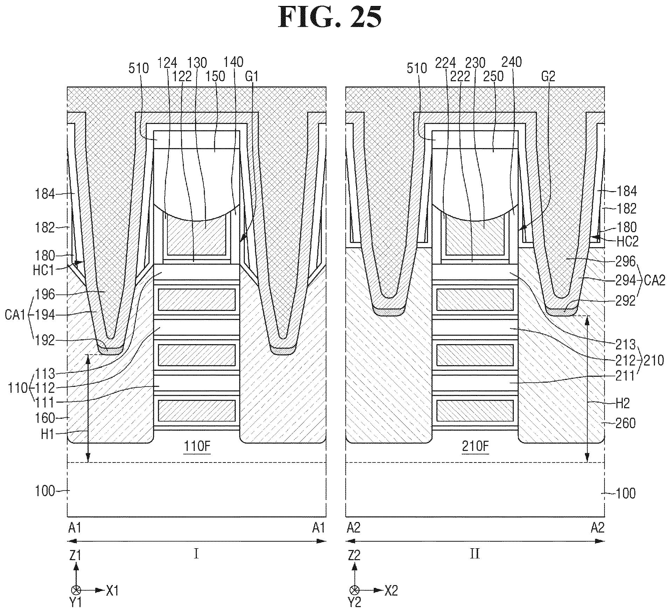

Referring to FIG. 25, in an embodiment, a first source/drain contact CA1 and a second source/drain contact CA2 are formed.

For example, a first barrier metal film 194 and a first metal film 196 are sequentially stacked inside the first contact hole HC1, and a second barrier metal film 294 and a second metal film 296 are sequentially stacked inside the second contact hole HC2. In some embodiments, as the first barrier metal film 194 is being deposited inside the first contact hole HC1, elements in the first barrier metal film 194 react with the first epitaxial pattern 160 to form the first silicide film 192. Similarly, as the second barrier metal film 294 is being deposited inside the second contact hole HC2, elements in the second barrier metal film 294 react with the second epitaxial pattern 260 to form the second silicide film 292. Accordingly, the first source/drain contact CA1 connected to the first epitaxial pattern 160 is formed, and the second source/drain contact CA2 connected to the second epitaxial pattern 260 is formed.

In some embodiments, the first barrier metal film 194 and the second barrier metal film 294 are formed at the same level, or at the same time, and the first metal film 196 and the second metal film 296 are formed at the same level, or at the same time.

Referring back to FIG. 2, in an embodiment, a planarization process is performed on the first barrier metal film 194 and the first metal film 196. The planarization process includes, for example, but is not necessarily limited to, a chemical-mechanical polishing (CMP) process. Therefore, the semiconductor device described above using FIGS. 1 to 5 is fabricated.

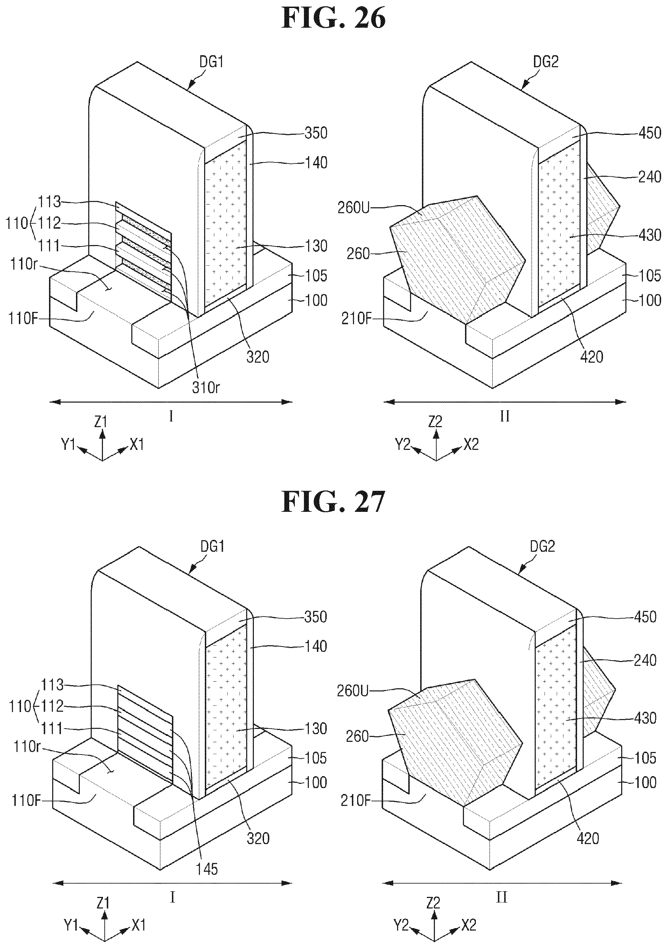

FIGS. 26 and 27 illustrate intermediate steps of a method for fabricating a semiconductor device according to some embodiments. For reference, FIG. 26 illustrates intermediate steps performed after FIG. 14.

Referring to FIG. 26, in an embodiment, a second recess process is performed on the first sacrificial pattern 310.

As the second recess process is being performed, the side surface of the first sacrificial pattern 310 exposed by the first recess 110r are recessed to form a third recess 3 10r. In addition, the first active pattern 110 protrudes beyond the first sacrificial pattern 310 in the first direction X1.

Referring to FIG. 27, in an embodiment, inner spacers 145 are formed on the side surfaces of the first sacrificial pattern 310.

The inner spacers 145 are formed to fill the third recess 3 10r of FIG. 26. For example, a spacer film is formed that conformally extends along the surface of the resulting product of FIG. 26. A recess process is performed on the spacer film. Accordingly, a plurality of inner spacers 145 are formed that are separated from each other by the first active pattern 110.

Steps described above using to FIGS. 15 to 25 can then be performed. Therefore, the semiconductor device described above using FIG. 11 is fabricated.

In concluding the detailed description, those skilled in the art will appreciate that many variations and modifications may be made to the disclosed embodiments without substantially departing from the principles of the present inventive concept. Therefore, the disclosed embodiments of the disclosure are used in a generic and descriptive sense only and not for purposes of limitation.

## Claims

1. A semiconductor device, comprising:
a substrate that includes a first region and a second region;
a first active pattern that extends in a first direction on the first region;
a first gate structure that extends in a second direction that intersects the first direction and that intersects the first active pattern;
a first epitaxial pattern disposed on a side surface of the first gate structure, wherein the first epitaxial pattern is connected to the first active pattern and includes n-type impurities;
a first source/drain contact that penetrates an upper surface of the first epitaxial pattern and is connected to the first epitaxial pattern;
a second active pattern that extends in a third direction on the second region;
a second gate structure that extends in a fourth direction that intersects the third direction and intersects the second active pattern;
a second epitaxial pattern disposed on a side surface of the second gate structure, wherein the second epitaxial pattern is connected to the second active pattern and includes p-type impurities; and
a second source/drain contact that penetrates an upper surface of the second epitaxial pattern and is connected to the second epitaxial pattern,
wherein a lower surface of the first source/drain contact is lower than a lower surface of the second source/drain contact.

2. The semiconductor device of claim 1,
wherein an upper surface of the first epitaxial pattern has a V shape in a cross-section that intersects the second direction.

3. The semiconductor device of claim 1,
wherein the first epitaxial pattern has a hexagonal shape in a cross-section that intersects the first direction.

4. The semiconductor device of claim 1,
wherein a height of the upper surface of the second epitaxial pattern adjacent to the second gate structure increases with increasing distance from the second gate structure.

5. The semiconductor device of claim 1,
wherein the second epitaxial pattern has a pentagonal shape in a cross-section that intersects the third direction.

6. The semiconductor device of claim 1, further comprising:
a first liner film that extends along the upper surface of the first epitaxial pattern, the side surface of the first gate structure, the upper surface of the second epitaxial pattern, and the side surface of the second gate structure; and
a second liner film disposed on the first liner film and that extends along a side surface of the first source/drain contact and a side surface of the second source/drain contact,.

7. The semiconductor device of claim 1, wherein
the first source/drain contact includes a first silicide film, a first barrier metal film, and a first filling metal film that are sequentially stacked on the first epitaxial pattern, and
the second source/drain contact includes a second silicide film, a second barrier metal film, and a second filling metal film that are sequentially stacked on the second epitaxial pattern.

8. The semiconductor device of claim 7, wherein
the first silicide film extends along the side surface and the lower surface of the first source/drain contact between the first epitaxial pattern and the first source/drain contact, and
the second silicide film extends along the side surface and the lower surface of the second source/drain contact between the second epitaxial pattern and the second source/drain contact.

9. The semiconductor device of claim 1, wherein
the first active pattern includes a plurality of first sheet patterns that are sequentially stacked on the substrate, vertically spaced apart from each other, and extend in the first direction, and
the second active pattern includes a plurality of second sheet patterns that are sequentially stacked on the substrate, vertically spaced apart from each other, and extend in the third direction.

10. A semiconductor device, comprising:
a substrate that includes a first region and a second region;
a first active pattern that extends in a first direction on the first region;
a first gate structure that extends in a second direction that intersects the first direction and intersects the first active pattern;
a first epitaxial pattern disposed on a side surface of the first gate structure, wherein the first epitaxial pattern is connected to the first active pattern and includes n-type impurities;
a first source/drain contact that penetrates an upper surface of the first epitaxial pattern and is connected to the first epitaxial pattern;
a second active pattern that extends in a third direction on the second region;
a second gate structure that extends in a fourth direction that intersects the third direction and intersects the second active pattern;
a second epitaxial pattern disposed on a side surface of the second gate structure, wherein the second epitaxial pattern is connected to the second active pattern and includes p-type impurities; and
a second source/drain contact that penetrates an upper surface of the second epitaxial pattern and is connected to the second epitaxial pattern,
wherein the upper surface of the first epitaxial pattern has a V shape in a cross-section that intersects the second direction, and
an uppermost part of the second epitaxial pattern is higher than an uppermost part of the first epitaxial pattern.

11. The semiconductor device of claim 10,
wherein a lower surface of the first source/drain contact is lower than a lower surface of the second source/drain contact.

12. The semiconductor device of claim 10,
wherein the first epitaxial pattern has a hexagonal shape in a cross-section that intersects the first direction.

13. The semiconductor device of claim 10,
wherein an area of the first epitaxial pattern decreases with increasing distance from the first gate structure in a cross-section that intersects the first direction.

14. The semiconductor device of claim 10,
wherein the upper surface of the first epitaxial pattern includes a {111} crystal plane.

15. The semiconductor device of claim 14,
wherein the upper surface of the substrate includes a {100} crystal plane.
